# EUROPEAN PATENT SPECIFICATION

(11) **EP 4 465 283 B1**
(45) Date of publication and mention of the grant of the patent: **02.07.2025**
(21) Application number: 24150401.8
(22) Date of filing: 04.01.2024
(51) Int. Cl.: G09F 9/302, G09F 9/33, G09G 3/32, H01R 13/631, H01R 13/70

(54) **PLUG-IN MECHANISM OF LED DISPLAY DEVICE, AND LED DISPLAY DEVICE**
STECKMECHANISMUS EINER LED-ANZEIGEVORRICHTUNG UND LED-ANZEIGEVORRICHTUNG
MÉCANISME ENFICHABLE DE DISPOSITIF D'AFFICHAGE À DEL ET DISPOSITIF D'AFFICHAGE À DEL

(30) Priority: 17.05.2023 CN 202310558677
(43) Date of publication of application: 20.11.2024
(73) Proprietor: Leyard Optoelectronic Co., Ltd, Beijing 100091 (CN)
(72) Inventor: WANG, Dingfang, Beijing, 100091 (CN); LU, Changjun, Beijing, 100091 (CN); LIU, Zhiyong, Beijing, 100091 (CN)
(74) Representative: HGF

(56) References cited:
- CN-A- 108 682 322
- CN-A- 114 286 572
- CN-B- 111 028 701
- US-A1- 2019 191 523
- US-A1- 2020 381 586
- US-A1- 2021 005 585
- US-A1- 2022 343 811

## Description

### Cross-Reference to Related Application

The present invention claims priority to Chinese Patent Application No. 202310558677.6, filed to the China National Intellectual Property Administration on May, 17, 2023 and entitled "Plug-in Mechanism of LED Display Device, and LED Display Device".

### Technical Field

The present invention relates to the technical field of LED display, in particular to a plug-in mechanism of an LED display device, and the LED display device.

### Background

In the technical field of light-emitting diode (LED) display, an LED display device includes a plurality of display units arranged side by side. When two adjacent display units are assembled, flexible and independent power lines and data lines are commonly used for connection.

However, during connection of power lines, the distribution of lines is complicated. In order to solve this problem, a plugging structure is provided in related art. The plugging structure includes a power supply plugging assembly and a signal plugging assembly. The power supply plugging assembly includes a power socket and a power plug inserted into the power socket, and the signal plugging assembly includes a signal socket and a signal plug inserted into the signal socket. The power supply plugging assembly and the signal plugging assembly are independently mounted at two side edges of two adjacent display units respectively. When the two adjacent display units are assembled, the power plug can be inserted into the power socket, and the signal plug can be inserted into the signal socket.

However, the power supply plugging assembly and the signal plugging assembly are separately arranged, the power plug is separately inserted into the power socket, the signal plug is separately inserted into the signal socket, and the assembling time of the power supply plugging assembly and the assembling time of the signal plugging assembly are relatively long, so the working efficiency is relatively low.

### Summary

A main objective of the present invention is to provide a plug-in mechanism of an LED display device, and the LED display device, so as to solve the problem that the working efficiency is relatively low due to the fact that the assembling time of the power supply plugging assembly and the assembling time of the signal plugging assembly are relatively long in the related art.

In order to achieve the above objective, according to one aspect of the present invention, a plug-in mechanism of an LED display device is provided, including: a first plug-in assembly and a second plug-in assembly which are cooperated with each other, wherein the first plug-in assembly includes a first seat body, a first power supply plug-in part, a first signal plug-in part, a first driving component, a second driving component and a function switching component; the first power supply plug-in part and the first signal plug-in part are movably arranged on the first seat body at an interval; the first driving component is movably arranged on the first seat body and drives the first power supply plug-in part to move; the second driving component is movably arranged on the first seat body and drives the first signal plug-in part to move, and the first driving component and the second driving component together form a driving part; the second plug-in assembly includes a second seat body, a second power supply plug-in part, a second signal plug-in part and a pushing part; the second power supply plug-in part and the second signal plug-in part are arranged on the second seat body at an interval; the pushing part protrudes towards an outer side of the second seat body and is arranged on the second seat body; the first power supply plug-in part has a first switching-on position where the first power supply plug-in part penetrates out of the first seat body and is in contact switching-on with the second power supply plug-in part and a first switching-off position where the first power supply plug-in part retracts into the first seat body and is separated from the second power supply plug-in part; the first signal plug-in part has a second switching-on position where the first signal plug-in part penetrates out of the first seat body and is in contact switching-on with the second signal plug-in part and a second switching-off position where the first signal plug-in part retracts into the first seat body and is separated from the second signal plug-in part; the function switching component is movably arranged on the first seat body; the function switching component has a first working position; when the function switching component is located at the first working position, the function switching component can drive the driving part to move; and when the function switching component is located at the first working position, the pushing part can be inserted into the first seat body and pushes the driving part to move through the function switching component, so as to enable the first power supply plug-in part to be switched from the first switching-off position to the first switching-on position and enable the first signal plug-in part to be switched from the second switching-off position to the second switching-on position, and the pushing part can be pulled out of the first seat body, so as to enable the first power supply plug-in part to be switched from the first switching-on position to the first switching-off position and enable the first signal plug-in part to be switched from the second switching-on position to the second switching-off position.

In some embodiments, the function switching component also has a second working position and a third working position, wherein when the function switching component is located at the second working position, the function switching component can drive the first driving component to move and avoid the second driving component; when the function switching component is located at the third working position, the function switching component can drive the second driving component to move and avoid the first driving component; when the function switching component is located at the second working position, the pushing part pushes the first driving component to move through the function switching component, so as to enable the first power supply plug-in part to be switched from the first switching-off position to the first switching-on position and enable the first signal plug-in part to be maintained at the second switching-off position; and when the function switching component is located at the third working position, the pushing part pushes the second driving component to move through the function switching component, so as to enable the first signal plug-in part to be switched from the second switching-off position to the second switching-on position and enable the first power supply plug-in part to be maintained at the first switching-off position.

In some embodiments, the function switching component also has a fourth working position; when the function switching component is located at the fourth working position, the function switching component avoids the driving part; and when the function switching component is located at the fourth working position, the pushing part pushes the function switching component to move, so as to enable the first power supply plug-in part to be maintained at the first switching-off position and enable the first signal plug-in part to be maintained at the second switching-off position.

In some embodiments, the first plug-in assembly further includes a first reset component and a second reset component which are arranged in the first seat body; the first reset component applies a first reset force for switching the first power supply plug-in part from the first switching-on position to the first switching-off position to the first driving component; and the second reset component applies a second reset force for switching the first signal plug-in part from the second switching-on position to the second switching-off position to the second driving component.

In some embodiments, the function switching component includes a function switching piece and a first lug and a second lug which are arranged on the function switching piece at an interval; and when the function switching component is located at the first working position, the first lug can drive the first driving component to move, and the second lug can drive the second driving component to move.

In some embodiments, the function switching component includes a function switching piece and a first lug and a second lug which are arranged on the function switching piece at an interval, a first gap is formed between the first lug and a side of the function switching piece provided with the first lug, and a second gap is formed between the second lug and a side of the function switching piece provided with the second lug; when the function switching component is located at the first working position, the first lug can drive the first driving component to move, and the second lug can drive the second driving component to move; when the function switching component is located at the second working position, the first lug can drive the first driving component to move, and the second gap avoids the second driving component; and when the function switching component is located at the third working position, the second lug can drive the second driving component to move, and the first gap avoids the first driving component.

In some embodiments, the function switching component further includes an operating key in inserted fit with the function switching piece, and the operating key drives the function switching piece to move in the first seat body, so as to enable the function switching component to be switched among the first working position, the second working position and the third working position.

In some embodiments, the first driving component includes a driving block and a driving plate, the driving block is movably arranged in the first seat body, the driving plate is swingingly arranged on the first seat body, and two ends of the driving plate are respectively articulated with the driving block and the first power supply plug-in part.

In some embodiments, the driving plate includes a first driving plate segment, a connecting plate segment and a second driving plate segment which are connected in sequence, the connecting plate segment is arranged on the first seat body through a rotating shaft, the first driving plate segment is provided with a first opening, the second driving plate segment is provided with a second opening, the driving block is provided with a first articulated column abutting against the first opening, and the first power supply plug-in part is provided with a second articulated column abutting against the second opening.

According to another aspect of the present invention, an LED display device is provided, including a first display unit, a second display unit and a plug-in mechanism, wherein the first display unit and the second display unit are arranged side by side, the plug-in mechanism is the plug-in mechanism of the LED display device mentioned above, the first plug-in assembly of the plug-in mechanism is mounted on a side edge of the first display unit adjacent to the second display unit, and the second plug-in assembly of the plug-in mechanism is mounted on a side edge of the second display unit adjacent to the first display unit.

By applying the technical scheme of the present invention, the plug-in mechanism of the LED display device includes the first plug-in assembly and the second plug-in assembly which are cooperated with each other. The first plug-in assembly of the plug-in mechanism of the LED display device can be mounted on one adjacent side edge of two adjacent display units, and the second plug-in assembly of the plug-in mechanism of the LED display device can be mounted on another adjacent side edge of the two adjacent display units. The first plug-in assembly includes the first seat body, the first power supply plug-in part, the first signal plug-in part, the first driving component, the second driving component and the function switching component. The first power supply plug-in part and the first signal plug-in part are movably arranged on the first seat body at an interval, the first driving component is movably arranged on the first seat body and drives the first power supply plug-in part to move, the second driving component is movably arranged on the first seat body and drives the first signal plug-in part to move, and the first driving component and the second driving component together form the driving part. The second plug-in assembly includes a second seat body, a second power supply plug-in part, a second signal plug-in part and a pushing part. The second power supply plug-in part and the second signal plug-in part are arranged on the second seat body at an interval, and the pushing part protrudes towards the outer side of the second seat body and is arranged on the second seat body. During the process of assembling two adjacent display units together, the first power supply plug-in part has the first switching-on position where the first power supply plug-in part penetrates out of the first seat body and is in contact switching-on with the second power supply plug-in part and the first switching-off position where the first power supply plug-in part retracts into the first seat body and is separated from the second power supply plug-in part, and the first signal plug-in part has the second switching-on position where the first signal plug-in part penetrates out of the first seat body and is in contact switching-on with the second signal plug-in part and the second switching-off position where the first signal plug-in part retracts into the first seat body and is separated from the second signal plug-in part. The function switching component is movably arranged on the first seat body, the function switching component has the first working position, and when the function switching component is located at the first working position, the function switching component can drive the driving part to move. When the function switching component is located at the first working position, the pushing part can be inserted into the first seat body and pushes the driving part to move through the function switching component, so as to enable the first power supply plug-in part to be switched from the first switching-off position to the first switching-on position and enable the first signal plug-in part to be switched from the second switching-off position to the second switching-on position; and the pushing part can be pulled out of the first seat body, so as to enable the first power supply plug-in part to be switched from the first switching-on position to the first switching-off position and enable the first signal plug-in part to be switched from the second switching-on position to the second switching-off position. During this process, this invention may be only provided with one plug-in mechanism of the LED display device, and the function switching component at the first working position can drive the driving part to move at a time, so as to form contact switching-on between the first power supply plug-in part and the second power supply plug-in part and contact switching-on between the first signal plug-in part and the second signal plug-in part. In the technical solution of this invention, the power supply plugging assembly and the signal plugging assembly which are separately arranged and are separately assembled in the related art are integrated, and the contact switching-on of the first plug-in assembly and the second plug-in assembly can be achieved during the mounting process of two display units, thus shortening the working time, reducing the workload, and increasing the working efficiency. Therefore, the technical solution of this invention effectively solves the problem that the working efficiency is relatively low due to the fact that the assembling time of the power supply plugging assembly and the assembling time of the signal plugging assembly are relatively long in the related art.

### Brief Description of the Drawings

The accompanying drawings of the specification that constitute a part of this application are used to provide a further understanding of the present invention. The exemplary embodiments of the present invention and the descriptions thereof are used to explain the present invention, and do not constitute an improper limitation on the present invention. In the accompanying drawings:
Fig. 1 shows a rear view of an embodiment of an LED display device according to the present invention;
Fig. 2 shows a partial enlarged view of a position A of the LED display device in Fig. 1;
Fig. 3 shows a rear view of a first display unit, a first plug-in assembly and a second plug-in assembly of the LED display device in Fig. 1;
Fig. 4 shows a schematic view of a three-dimensional structure of a plug-in mechanism of the LED display device according to the present invention;
Fig. 5 shows a schematic view of a breakdown structure of the first plug-in assembly of the plug-in mechanism of the LED display device in Fig. 4;
Fig. 6 shows a schematic view of a partial breakdown structure of the first plug-in assembly of the plug-in mechanism of the LED display device in Fig. 4;
Fig. 7 shows a schematic bottom view of a partial structure of a function switching component at a first working position of the plug-in mechanism of the LED display device in Fig. 4; and
Fig. 8 shows a schematic perspective view of a three-dimensional structure of the function switching component at a second working position of the plug-in mechanism of the LED display device in Fig. 4.

The above accompanying drawings have the following reference numerals:
10. first plug-in assembly; 11. first seat body; 111. third slide groove; 112. first guide groove; 113. second guide groove; 12. first power supply plug-in part; 13. second articulated column; 14. first signal plug-in part;
15. first driving component; 151. driving block; 152. first articulated column; 153. driving plate; 1531. first driving plate segment; 1532. connecting plate segment; 1533. second driving plate segment; 1534. first opening; 1535. second opening; 154. driving seat; 1541. first slide groove; 1542. second slide groove; 1543. first through hole; 1544. second through hole; 155. support plate;
16. second driving component;
17. function switching component; 171. function switching piece; 172. first lug; 173. second lug; 174. first gap; 175. second gap; 176. operating key;
20. second plug-in assembly; 201. second seat body; 202. second power supply plug-in part; 21. first reset component; 22. second reset component;
23. second signal plug-in part; 24. pushing part;
31. first display unit; 32. second display unit.

### Detailed Description of the Embodiments

The technical solution in the embodiments of the present invention will be clearly and completely described below with reference to the accompanying drawings in the embodiments of the present invention. Obviously, the described embodiments are only a part rather than all of the embodiments of the present invention. The following descriptions of at least one exemplary embodiment are actually only illustrative, and in no way constitute any limitation on the present invention and the application or use of the present invention. Based on the embodiments in the present invention, all other embodiments obtained by those of ordinary skill in the art without creative efforts fall within the protection scope of the present invention.

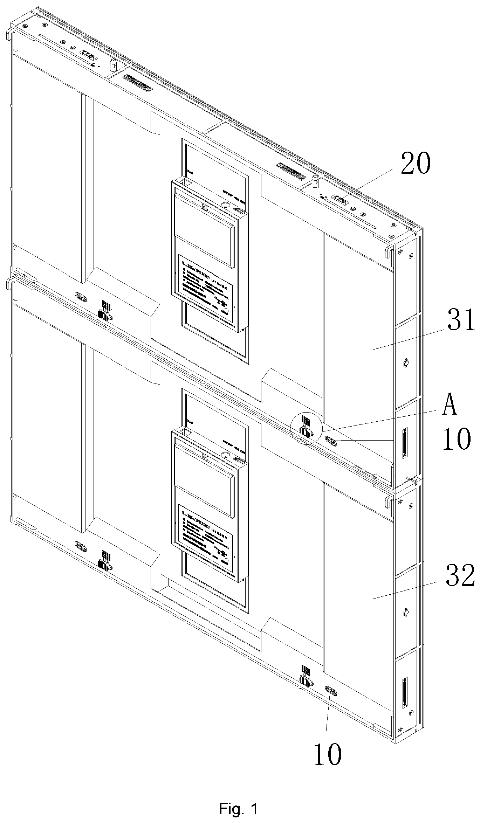

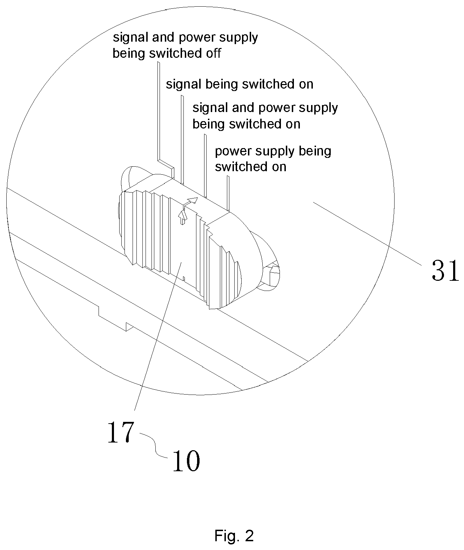

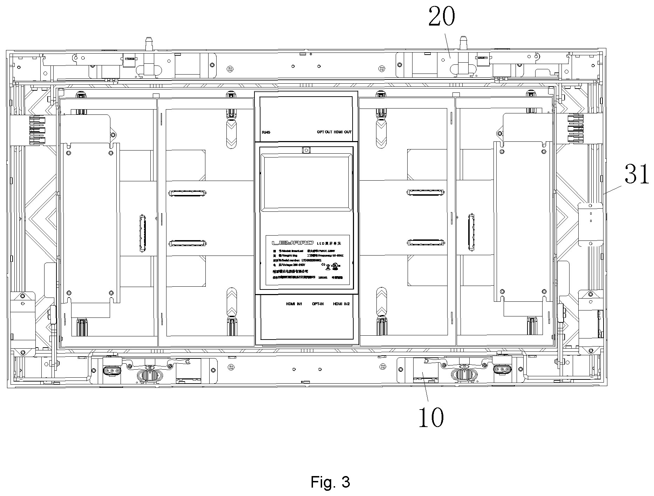

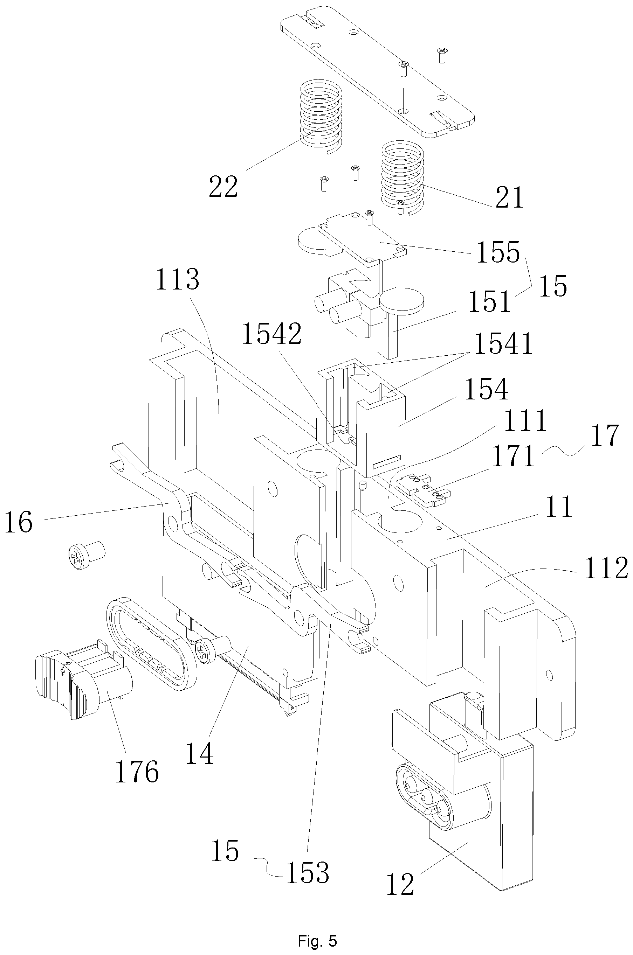

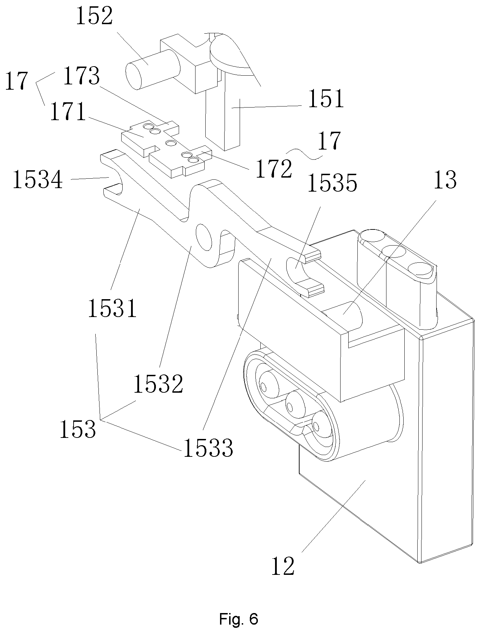

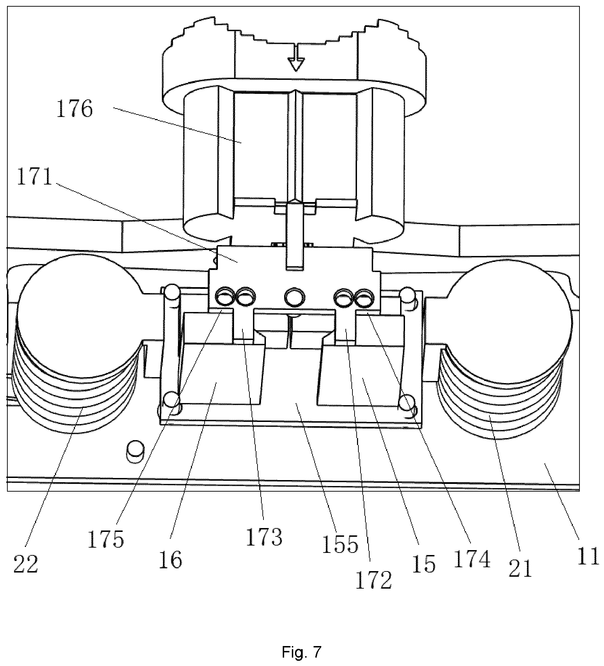

As shown in Fig. 1 to Fig. 7, a plug-in mechanism of an LED display device in this embodiment includes a first plug-in assembly 10 and a second plug-in assembly 20 which are cooperated with each other. The first plug-in assembly 10 includes a first seat body 11, a first power supply plug-in part 12, a first signal plug-in part 14, a first driving component 15, a second driving component 16 and a function switching component 17. The first power supply plug-in part 12 and the first signal plug-in part 14 are movably arranged on the first seat body 11 at an interval, the first driving component 15 is movably arranged on the first seat body 11 and drives the first power supply plug-in part 12 to move, the second driving component 16 is movably arranged on the first seat body 11 and drives the first signal plug-in part 14 to move, and the first driving component 15 and the second driving component 16 together form a driving part. The second plug-in assembly 20 includes a second seat body 201, a second power supply plug-in part 202, a second signal plug-in part 23 and a pushing part 24. The second power supply plug-in part 202 and the second signal plug-in part 23 are arranged on the second seat body 201 at an interval, and the pushing part 24 protrudes towards an outer side of the second seat body 201 and is arranged on the second seat body 201. The first power supply plug-in part 12 has a first switching-on position where the first power supply plug-in part 12 penetrates out of the first seat body 11 and is in contact switching-on with the second power supply plug-in part 202 and a first switching-off position where the first power supply plug-in part 12 retracts into the first seat body 11 and is separated from the second power supply plug-in part 202, and the first signal plug-in part 14 has a second switching-on position where the first signal plug-in part 14 penetrates out of the first seat body 11 and is in contact switching-on with the second signal plug-in part 23 and a second switching-off position where the first signal plug-in part 14 retracts into the first seat body 11 and is separated from the second signal plug-in part 23. The function switching component 17 is movably arranged on the first seat body 11, the function switching component 17 has a first working position, and when the function switching component 17 is located at the first working position, the function switching component 17 can drive the driving part to move. When the function switching component 17 is located at the first working position, the pushing part 24 can be inserted into the first seat body 11 and pushes the driving part to move through the function switching component 17, so as to enable the first power supply plug-in part 12 to be switched from the first switching-off position to the first switching-on position and enable the first signal plug-in part 14 to be switched from the second switching-off position to the second switching-on position, and the pushing part 24 can be pulled out of the first seat body 11, so as to enable the first power supply plug-in part 12 to be switched from the first switching-on position to the first switching-off position and enable the first signal plug-in part 14 to be switched from the second switching-on position to the second switching-off position.

By applying the technical solution of this embodiment, the plug-in mechanism of the LED display device includes the first plug-in assembly 10 and the second plug-in assembly 20 which are cooperated with each other. The first plug-in assembly 10 of the plug-in mechanism of the LED display device can be mounted on one adjacent side edge of two adjacent display units, and the second plug-in assembly 20 of the plug-in mechanism of the LED display device can be mounted on another adjacent side edge of the two adjacent display units. During the process of assembling two adjacent display units together, the first power supply plug-in part 12 has the first switching-on position where the first power supply plug-in part 12 penetrates out of the first seat body 11 and is in contact switching-on with the second power supply plug-in part 202 and the first switching-off position where the first power supply plug-in part 12 retracts into the first seat body 11 and is separated from the second power supply plug-in part 202, and the first signal plug-in part 14 has the second switching-on position where the first signal plug-in part 14 penetrates out of the first seat body 11 and is in contact switching-on with the second signal plug-in part 23 and the second switching-off position where the first signal plug-in part 14 retracts into the first seat body 11 and is separated from the second signal plug-in part 23. The function switching component 17 is movably arranged on the first seat body 11, the function switching component 17 has the first working position, and when the function switching component 17 is located at the first working position, the function switching component 17 can drive the driving part to move. When the function switching component 17 is located at the first working position, the pushing part 24 can be inserted into the first seat body 11 and pushes the driving part to move through the function switching component 17, so as to enable the first power supply plug-in part 12 to be switched from the first switching-off position to the first switching-on position and enable the first signal plug-in part 14 to be switched from the second switching-off position to the second switching-on position; and the pushing part 24 can be pulled out of the first seat body 11, so as to enable the first power supply plug-in part 12 to be switched from the first switching-on position to the first switching-off position and enable the first signal plug-in part 14 to be switched from the second switching-on position to the second switching-off position. During this process, this embodiment may be only provided with one plug-in mechanism of the LED display device, and the function switching component 17 at the first working position can drive the driving part to move at a time, so as to form contact switching-on between the first power supply plug-in part 12 and the second power supply plug-in part 202 and contact switching-on between the first signal plug-in part 14 and the second signal plug-in part 23. In the technical solution of this embodiment, the power supply plugging assembly and the signal plugging assembly which are separately arranged and are separately assembled in the related art are integrated, and the contact switching-on of the first plug-in assembly 10 and the second plug-in assembly 20 can be achieved during the mounting process of two display units, thus shortening the working time, reducing the workload, and increasing the working efficiency. Therefore, the technical solution of this embodiment effectively solves the problem that the working efficiency is relatively low due to the fact that the assembling time of the power supply plugging assembly and the assembling time of the signal plugging assembly are relatively long in the related art.

In this embodiment, in order to push the function switching component 17 by the pushing part 24 to enable the first power supply plug-in part 12 and the first signal plug-in part 14 to synchronously move and be synchronously plugged with the second power supply plug-in part 202 and the second signal plug-in part 23 respectively to facilitate force application, the first power supply plug-in part 12 and the first signal plug-in part 14 are located on two sides of the function switching component 17, the pushing part 24 is preferably a pushing pin, and the second power supply plug-in part 202 and the second signal plug-in part 23 are located on two sides of the pushing pin. A first guide groove 112 and a second guide groove 113 are arranged on the first seat body 11 at an interval, the first power supply plug-in part 12 is located in the first guide groove 112, and the first signal plug-in part 14 is located in the second guide groove 113.

As shown in Fig. 1 to Fig. 7, during the mounting or debugging process of the plurality of display units, it is necessary to ensure that the power supplies and signals of some display units are both switched on, or only the power supplies or signals are switched on, or both the power supplies and signals are not switched on, so as to adapt to mounting or debugging requirements, and the above-mentioned first working position is a position where the signals and power supplies are switched on. When the function switching component 17 is located at the first working position, the first power supply plug-in part 12 is switched from the first switching-off position to the first switching-on position, and the first signal plug-in part 14 is switched from the second switching-off position to the second switching-on position. In this way, the function switching component 17 first selects a function to meet the mounting or debugging requirements of the display units in which the power supplies and signals are switched on.

As shown in Fig. 1 to Fig. 7, the function switching component 17 also has a second working position and a third working position. When the function switching component 17 is located at the second working position, the function switching component 17 can drive the first driving component 15 to move and avoid the second driving component 16; and when the function switching component 17 is located at the third working position, the function switching component 17 can drive the second driving component 16 to move and avoid the first driving component 15. When the function switching component 17 is located at the second working position, the pushing part 24 pushes the first driving component 15 to move through the function switching component 17, so as to enable the first power supply plug-in part 12 to be switched from the first switching-off position to the first switching-on position and enable the first signal plug-in part 14 to be maintained at the second switching-off position. In this way, the function switching component 17 first selects a function to meet the mounting or debugging requirements of the display units in which only the power supplies are switched on. When the function switching component 17 is located at the third working position, the pushing part 24 pushes the second driving component 16 to move through the function switching component 17, so as to enable the first signal plug-in part 14 to be switched from the second switching-off position to the second switching-on position and enable the first power supply plug-in part 12 to be maintained at the first switching-off position. In this way, the function switching component 17 first selects a function to meet the mounting or debugging requirements of the display units in which only the signals are switched on. The above-mentioned second working position is a position where the power supply is switched on, and the above-mentioned third working position is a position where the signal is switched on.

As shown in Fig. 1 to Fig. 7, the function switching component 17 also has a fourth working position. When the function switching component 17 is located at the fourth working position, the function switching component 17 avoids the driving part. When the function switching component 17 is located at the fourth working position, the pushing part 24 pushes the function switching component 17 to move, so as to enable the first power supply plug-in part 12 to be maintained at the first switching-off position and enable the first signal plug-in part 14 to be maintained at the second switching-off position. In this way, the function switching component 17 first selects a function to meet the mounting or debugging requirements of the display units in which both the power supplies and signals are not switched on. The above-mentioned fourth working position is a position where the signal and power supply are switched off.

As shown in Fig. 1 to Fig. 7, in order to facilitate the automatic switching of the first power supply plug-in part 12 from the first switching-on position to the first switching-off position, and the automatic switching of the first signal plug-in part 14 from the second switching-on position to the second switching-off position, the first plug-in assembly 10 further includes a first reset component 21 and a second reset component 22 which are arranged in the first seat body 11. The first reset component 21 applies a first reset force for switching the first power supply plug-in part 12 from the first switching-on position to the first switching-off position to the first driving component 15, and the second reset component 22 applies a second reset force for switching the first signal plug-in part 14 from the second switching-on position to the second switching-off position to the second driving component 16. In this way, the separation of the first plug-in assembly 10 and the second plug-in assembly 20 can be achieved during the disassembly process of two display units, thus further shortening the working time, reducing the workload, and greatly increasing the working efficiency. The first reset component 21 and the second reset component 22 are both preferably compression springs.

As shown in Fig. 1 to Fig. 7, the function switching component 17 includes a function switching piece 171 and a first lug 172 and a second lug 173 which are arranged on the function switching piece 171 at an interval. When the function switching component 17 is located at the first working position, the first lug 172 can drive the first driving component 15 to move, and the second lug 173 can drive the second driving component 16 to move.

As shown in Fig. 1 to Fig. 7, in order to achieve the corresponding functions in the case that the function switching component 17 is located at the first working position, the second working position and the third working position, the function switching component 17 includes a function switching piece 171 and a first lug 172 and a second lug 173 which are arranged on the function switching piece 171 at an interval, a first gap 174 is formed between the first lug 172 and a side of the function switching piece 171 provided with the first lug 172, and a second gap 175 is formed between the second lug 173 and a side of the function switching piece 171 provided with the second lug 173. When the function switching component 17 is located at the first working position, the first lug 172 can drive the first driving component 15 to move, and the second lug 173 can drive the second driving component 16 to move. At this time, the function switching piece 171 can simultaneously push the first lug 172 and the second lug 173 thereon to move together, so as to simultaneously drive the driving part to move.

As shown in Fig. 1 to Fig. 7, when the function switching component 17 is located at the second working position, the first lug 172 can drive the first driving component 15 to move, and the second gap 175 avoids the second driving component 16. In this way, during the moving process of the function switching component 17, the second driving component 16 is avoided, the first signal plug-in part 14 is maintained at the second switching-off position, and the function switching piece 171 can only push the first lug 172 thereon to move together, so as to drive the first driving component 15 to move. When the function switching component 17 is located at the third working position, the second lug 173 can drive the second driving component 16 to move, and the first gap 174 avoids the first driving component 15. In this way, during the moving process of the function switching component 17, the first driving component 15 is avoided, the first power supply plug-in part 12 is maintained at the first switching-off position, and the function switching piece 171 can only push the second lug 173 thereon to move together, so as to drive the second driving component 16 to move.

As shown in Fig. 1 to Fig. 7, when the function switching component 17 is located at the fourth working position, the first gap 174 avoids the first driving component 15, and the second gap 175 avoids the second driving component 16. In this way, during the moving process of the function switching component 17, the driving part is avoided simultaneously, the first power supply plug-in part 12 is maintained at the first switching-off position, the first signal plug-in part 14 is maintained at the second switching-off position, and the function switching piece 171 can drive the first lug 172 and the second lug 173 thereon to move together, so as to achieve the movement of the function switching component 17 only.

As shown in Fig. 1 to Fig. 7, for the convenience of operation, the function switching component 17 further includes an operating key 176 in inserted fit with the function switching piece 171, and the operating key 176 drives the function switching piece 171 to move in the first seat body 11, so as to enable the function switching component 17 to be switched among the first working position, the second working position and the third working position.

Specifically, the operating key 176 drives the function switching piece 171 to move in the first seat body 11, so as to enable the function switching component 17 to be switched among the first working position, the second working position, the third working position and the fourth working position.

As shown in Fig. 1 to Fig. 7, the first driving component 15 includes a driving block 151 and a driving plate 153, the driving block 151 is movably arranged in the first seat body 11, the driving plate 153 is swingingly arranged on the first seat body 11, and two ends of the driving plate 153 are respectively articulated with the driving block 151 and the first power supply plug-in part 12. In this way, the driving plate 153 can form a lever component so as to be convenient to drive the driving plate 153 to swing when the driving block 151 is subjected to an acting force.

In this embodiment, the structure of the second driving component 16 is the same as the structure of the first driving component 15.

As shown in Fig. 1 to Fig. 7, the driving plate 153 includes a first driving plate segment 1531, a connecting plate segment 1532 and a second driving plate segment 1533 which are connected in sequence. The connecting plate segment 1532 is arranged on the first seat body 11 through a rotating shaft, the first driving plate segment 1531 is provided with a first opening 1534, the second driving plate segment 1533 is provided with a second opening 1535, the driving block 151 is provided with a first articulated column 152 abutting against the first opening 1534, and the first power supply plug-in part 12 is provided with a second articulated column 13 abutting against the second opening 1535. In this way, during the process that the driving block 151 drives the first power supply plug-in part 12 to move through the driving plate 153, an inner side wall of the first opening 1534 can abut against the first articulated column 152, and the inner side wall of the first opening 1534 rotates around an outer side wall of the first articulated column 152, so as to stably support the first articulated column 152; and an inner side wall of the second opening 1535 can abut against the second articulated column 13, and the inner side wall of the second opening 1535 rotates around an outer side wall of the second articulated column 13, so as to stably support the second articulated column 13, to enable the first power supply plug-in part 12 to move stably. An axis of the first articulated column 152 is preferably perpendicular to a side surface of the driving block 151, and an axis of the second articulated column 13 is preferably perpendicular to a side surface of the first power supply plug-in part 12.

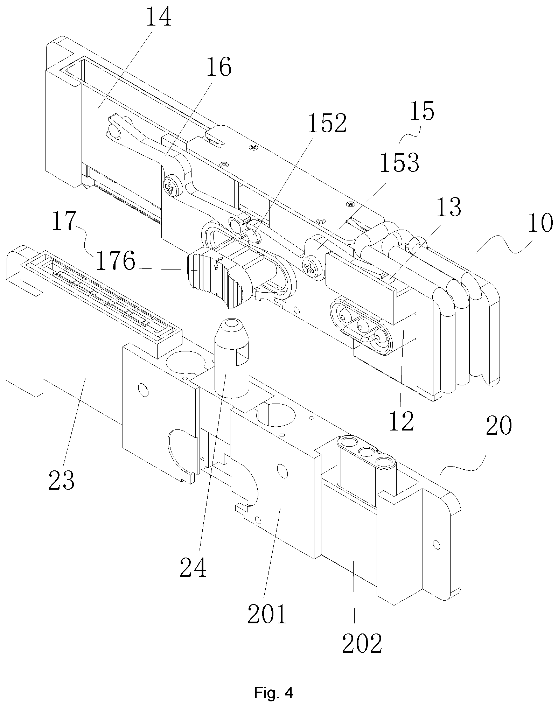

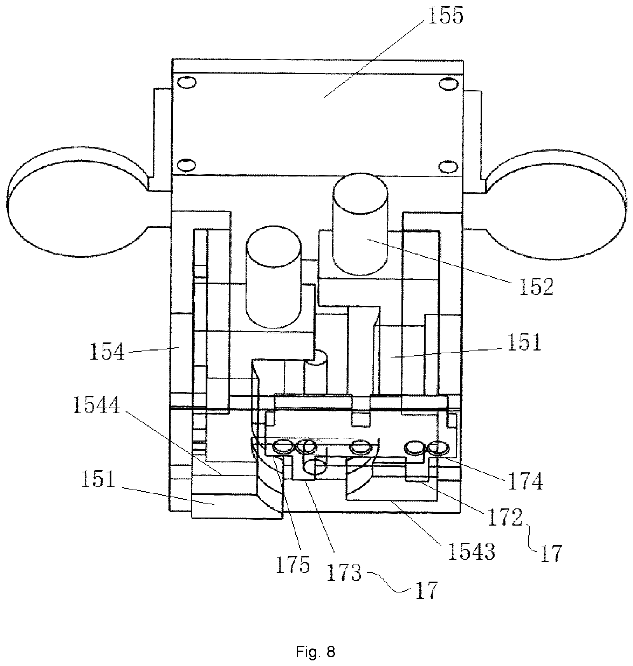

As shown in Fig. 4 to Fig. 8, in this embodiment, the first plug-in assembly 10 further includes a driving seat 154 movably arranged in the first seat body 11 and a support plate 155 fixedly connected with the driving seat 154. The first reset component 21 and the second reset component 22 are arranged between the support plate 155 and inner walls of the first seat body 11 at an interval. A moving direction of the driving seat 154 is parallel to a moving direction of the first driving component 15 and a moving direction of the second driving component 16. The function switching component 17 is movably threaded in the driving seat 154, and a moving direction of the function switching component 17 is perpendicular to the moving direction of the driving seat 154. A first slide groove 1541 for movable arrangement of the driving block 151 and a second slide groove 1542 for movable arrangement of the function switching component 17 are arranged in the driving seat 154, and a third slide groove 111 in guide fit with the driving seat 154 is arranged in the first seat body 11. The function switching component 17 moves with the driving seat 154. When the function switching component 17 is located at the first, second, third or fourth working position, the pushing part 24 drives the driving seat 154 to move so as to drive the function switching component 17 to move.

As shown in Fig. 4 to Fig. 8, the function switching component 17 is located between a first end of the driving seat 154 and the driving block 151, and the support plate 155 is connected with a second end of the driving seat 154. The driving block 151 of the first driving component 15 is a first driving block, and the driving block 151 of the second driving component 16 is a second driving block. A first through hole 1543 and a second through hole 1544 are arranged at the first end of the driving seat 154 at an interval, the first through hole 1543 is used for a part of the first driving block to penetrate through, and the second through hole 1544 is used for a part of the second driving block to penetrate through.

When the function switching component 17 is located at the first working position, the function switching component 17 shields the first through hole 1543 and the second through hole 1544, and the pushing part 24 is inserted into the first seat body 11 and pushes the first driving block and the second driving block to move through the driving seat 154 and the function switching component 17, so as to enable the first driving component 15 and the second driving component 16 to move synchronously.

When the function switching component 17 is located at the second working position, the function switching component 17 shields the first through hole 1543 and avoids the second through hole 1544, and the pushing part 24 only pushes the first driving block to move through the driving seat 154 and the function switching component 17. At this time, a part of the second driving block can penetrate through the second through hole 1544, to only push the first driving component 15 to move and keep the position of the second driving component 16 stationary.

When the function switching component 17 is located at the third working position, the function switching component 17 shields the second through hole 1544 and avoids the first through hole 1543, and the pushing part 24 only pushes the second driving block to move through the driving seat 154 and the function switching component 17. At this time, a part of the first driving block can penetrate through the first through hole 1543, to only push the second driving component 16 to move and keep the position of the first driving component 15 stationary.

When the function switching component 17 is located at the fourth working position, the function switching component 17 avoids the first through hole 1543 and the second through hole 1544, and the pushing part 24 only pushes the driving seat 154 and the function switching component 17 to move. At this time, a part of the first driving block can penetrate through the first through hole 1543, and a part of the second driving block can penetrate through the second through hole 1544, so as to keep the positions of both the first driving component 15 and the second driving component 16 stationary.

This invention further provides an LED display device. As shown in Fig. 1 to Fig. 3, the LED display device of this embodiment includes a first display unit 31, a second display unit 32 and a plug-in mechanism. The first display unit 31 and the second display unit 32 are arranged side by side. The plug-in mechanism is the plug-in mechanism of the LED display device mentioned above. The first display unit 31 is one of the two adjacent display units mentioned above, and the second display unit 32 is the other one of the two adjacent display units mentioned above. The first plug-in assembly 10 of the plug-in mechanism is mounted on a side edge of the first display unit 31 adjacent to the second display unit 32, and the second plug-in assembly 20 of the plug-in mechanism is mounted on a side edge of the second display unit 32 adjacent to the first display unit 31. Because the above-mentioned plug-in mechanism of the LED display device can solve the problem that the working efficiency is relatively low due to the fact that the assembling time of the power supply plugging assembly and the assembling time of the signal plugging assembly are relatively long in the related art, the LED display device with the plug-in mechanism can solve the same technical problem.

It should be noted that the terms used here are only used to describe specific embodiments, and are not intended to limit the exemplary embodiments according to this application. As used here, unless explicitly stated in the context, the singular form is also intended to include the plural form. In addition, it should also be understood that when the terms "comprising" and/or "including" are used in the specification, they indicate the presence of features, steps, operations, devices, components, and/or combinations thereof.

In addition, it should be noted that using words such as "first" and "second" to define parts is only intended to facilitate the differentiation of corresponding parts. Unless otherwise stated, the above words have no special meanings and therefore cannot be understood as limiting the protection scope of the present invention.

The scope of protection of the present invention is as defined in the appended claims. Any embodiment not falling within such scope should be construed as examples which do not describe parts of the invention.

## Claims

1. A plug-in mechanism of an LED display device, comprising: a first plug-in assembly (10) and a second plug-in assembly (20) which are cooperated with each other, wherein
the first plug-in assembly (10) comprises a first seat body (11), a first power supply plug-in part (12), a first signal plug-in part (14), a first driving component (15), a second driving component (16) and a function switching component (17), the first power supply plug-in part (12) and the first signal plug-in part (14) are movably arranged on the first seat body (11) at an interval, the first driving component (15) is movably arranged on the first seat body (11) and drives the first power supply plug-in part (12) to move, the second driving component (16) is movably arranged on the first seat body (11) and drives the first signal plug-in part (14) to move, and the first driving component (15) and the second driving component (16) together form a driving part;
the second plug-in assembly (20) comprises a second seat body (201), a second power supply plug-in part (202), a second signal plug-in part (23) and a pushing part (24), the second power supply plug-in part (202) and the second signal plug-in part (23) are arranged on the second seat body (201) at an interval, and the pushing part (24) protrudes towards an outer side of the second seat body (201) and is arranged on the second seat body (201);
the first power supply plug-in part (12) has a first switching-on position where the first power supply plug-in part (12) penetrates out of the first seat body (11) and is in contact switching-on with the second power supply plug-in part (202) and a first switching-off position where the first power supply plug-in part (12) retracts into the first seat body (11) and is separated from the second power supply plug-in part (202), and the first signal plug-in part (14) has a second switching-on position where the first signal plug-in part (14) penetrates out of the first seat body (11) and is in contact switching-on with the second signal plug-in part (23) and a second switching-off position where the first signal plug-in part (14) retracts into the first seat body (11) and is separated from the second signal plug-in part (23);
the function switching component (17) is movably arranged on the first seat body (11), the function switching component (17) has a first working position, and when the function switching component (17) is located at the first working position, the function switching component (17) can drive the driving part to move; and
when the function switching component (17) is located at the first working position, the pushing part (24) can be inserted into the first seat body (11) and pushes the driving part to move through the function switching component (17), so as to enable the first power supply plug-in part (12) to be switched from the first switching-off position to the first switching-on position and enable the first signal plug-in part (14) to be switched from the second switching-off position to the second switching-on position, and
the pushing part (24) can be pulled out of the first seat body (11), so as to enable the first power supply plug-in part (12) to be switched from the first switching-on position to the first switching-off position and enable the first signal plug-in part (14) to be switched from the second switching-on position to the second switching-off position.

2. The plug-in mechanism of the LED display device according to claim 1, wherein
the function switching component (17) also has a second working position and a third working position,
wherein when the function switching component (17) is located at the second working position, the function switching component (17) can drive the first driving component (15) to move and avoid the second driving component (16); when the function switching component (17) is located at the third working position, the function switching component (17) can drive the second driving component (16) to move and avoid the first driving component (15);
when the function switching component (17) is located at the second working position, the pushing part (24) pushes the first driving component (15) to move through the function switching component (17), so as to enable the first power supply plug-in part (12) to be switched from the first switching-off position to the first switching-on position and enable the first signal plug-in part (14) to be maintained at the second switching-off position; and
when the function switching component (17) is located at the third working position, the pushing part (24) pushes the second driving component (16) to move through the function switching component (17), so as to enable the first signal plug-in part (14) to be switched from the second switching-off position to the second switching-on position and enable the first power supply plug-in part (12) to be maintained at the first switching-off position.

3. The plug-in mechanism of the LED display device according to claim 1, wherein the function switching component (17) also has a fourth working position; when the function switching component (17) is located at the fourth working position, the function switching component (17) avoids the driving part; and when the function switching component (17) is located at the fourth working position, the pushing part (24) pushes the function switching component (17) to move, so as to enable the first power supply plug-in part (12) to be maintained at the first switching-off position and enable the first signal plug-in part (14) to be maintained at the second switching-off position.

4. The plug-in mechanism of the LED display device according to claim 1, wherein the first plug-in assembly (10) further comprises a first reset component (21) and a second reset component (22) which are arranged in the first seat body (11); the first reset component (21) applies a first reset force for switching the first power supply plug-in part (12) from the first switching-on position to the first switching-off position to the first driving component (15); and the second reset component (22) applies a second reset force for switching the first signal plug-in part (14) from the second switching-on position to the second switching-off position to the second driving component (16).

5. The plug-in mechanism of the LED display device according to claim 1, wherein the function switching component (17) comprises a function switching piece (171) and a first lug (172) and a second lug (173) which are arranged on the function switching piece (171) at an interval; and when the function switching component (17) is located at the first working position, the first lug (172) can drive the first driving component (15) to move, and the second lug (173) can drive the second driving component (16) to move.

6. The plug-in mechanism of the LED display device according to claim 2, wherein
the function switching component (17) comprises a function switching piece (171) and a first lug (172) and a second lug (173) which are arranged on the function switching piece (171) at an interval, a first gap (174) is formed between the first lug (172) and a side of the function switching piece (171) provided with the first lug (172), and a second gap (175) is formed between the second lug (173) and a side of the function switching piece (171) provided with the second lug (173);
when the function switching component (17) is located at the first working position, the first lug (172) can drive the first driving component (15) to move, and the second lug (173) can drive the second driving component (16) to move;
when the function switching component (17) is located at the second working position, the first lug (172) can drive the first driving component (15) to move, and the second gap (175) avoids the second driving component (16); and
when the function switching component (17) is located at the third working position, the second lug (173) can drive the second driving component (16) to move, and the first gap (174) avoids the first driving component (15).

7. The plug-in mechanism of the LED display device according to claim 6, wherein the function switching component (17) further comprises an operating key (176) in inserted fit with the function switching piece (171), and the operating key (176) drives the function switching piece (171) to move in the first seat body (11), so as to enable the function switching component (17) to be switched among the first working position, the second working position and the third working position.

8. The plug-in mechanism of the LED display device according to claim 1, wherein the first driving component (15) comprises a driving block (151) and a driving plate (153), the driving block (151) is movably arranged in the first seat body (11), the driving plate (153) is swingingly arranged on the first seat body (11), and two ends of the driving plate (153) are respectively articulated with the driving block (151) and the first power supply plug-in part (12).

9. The plug-in mechanism of the LED display device according to claim 8, wherein the driving plate (153) comprises a first driving plate segment (1531), a connecting plate segment (1532) and a second driving plate segment (1533) which are connected in sequence, the connecting plate segment (1532) is arranged on the first seat body (11) through a rotating shaft, the first driving plate segment (1531) is provided with a first opening (1534), the second driving plate segment (1533) is provided with a second opening (1535), the driving block (151) is provided with a first articulated column (152) abutting against the first opening (1534), and the first power supply plug-in part (12) is provided with a second articulated column (13) abutting against the second opening (1535).

10. An LED display device, comprising a first display unit (31), a second display unit (32) and a plug-in mechanism, wherein the first display unit (31) and the second display unit (32) are arranged side by side, the plug-in mechanism is the plug-in mechanism of the LED display device according to any one of claims 1 to 9, the first plug-in assembly (10) of the plug-in mechanism is mounted on a side edge of the first display unit (31) adjacent to the second display unit (32), and the second plug-in assembly (20) of the plug-in mechanism is mounted on a side edge of the second display unit (32) adjacent to the first display unit (31).

## Patentansprüche

1. Steckmechanismus einer LED-Anzeigevorrichtung, umfassend: eine erste Steckbaugruppe (10) und eine zweite Steckbaugruppe (20), die miteinander zusammenwirken, wobei
die erste Steckbaugruppe (10) einen ersten Sitzkörper (11), ein erstes Stromversorgungssteckteil (12), ein erstes Signalsteckteil (14), eine erste Antriebskomponente (15), eine zweite Antriebskomponente (16) und eine Funktionsschaltkomponente (17) umfasst, das erste Stromversorgungssteckteil (12) und das erste Signalsteckteil (14) bewegbar an dem ersten Sitzkörper (11) in einem Intervall angeordnet sind, die erste Antriebskomponente (15) bewegbar an dem ersten Sitzkörper (11) angeordnet ist und das erste Stromversorgungssteckteil (12) zum Bewegen antreibt, die zweite Antriebskomponente (16) bewegbar an dem ersten Sitzkörper (11) angeordnet ist und das erste Signalsteckteil (14) zum Bewegen antreibt und die erste Antriebskomponente (15) und die zweite Antriebskomponente (16) zusammen ein Antriebsteil bilden;
die zweite Steckbaugruppe (20) einen zweiten Sitzkörper (201), ein zweites Stromversorgungssteckteil (202), ein zweites Signalsteckteil (23) und ein Schiebeteil (24) umfasst, das zweite Stromversorgungssteckteil (202) und das zweite Signalsteckteil (23) an dem zweiten Sitzkörper (201) in einem Intervall angeordnet sind und das Schiebeteil (24) zu einer Außenseite des zweiten Sitzkörpers (201) vorsteht und an dem zweiten Sitzkörper (201) angeordnet ist;
das erste Stromversorgungssteckteil (12) eine erste Einschaltposition, in der das erste Stromversorgungssteckteil (12) aus dem ersten Sitzkörper (11) penetriert und in Kontakt mit dem zweiten Stromversorgungssteckteil (202) eingeschaltet ist, und eine erste Ausschaltposition, in der das erste Stromversorgungssteckteil (12) in den ersten Sitzkörper (11) eingezogen ist und von dem zweiten Stromversorgungssteckteil (202) getrennt ist, aufweist, und das erste Signalsteckteil (14) eine zweite Einschaltposition, in der das erste Signalsteckteil (14) aus dem ersten Sitzkörper (11) penetriert und in Kontakt mit dem zweiten Signalsteckteil (23) eingeschaltet ist, und eine zweite Ausschaltposition, in der das erste Signalsteckteil (14) in den ersten Sitzkörper (11) eingezogen ist und von dem zweiten Signalsteckteil (23) getrennt ist, aufweist;
die Funktionsschaltkomponente (17) bewegbar an dem ersten Sitzkörper (11) angeordnet ist, die Funktionsschaltkomponente (17) eine erste Arbeitsposition aufweist und, wenn sich die Funktionsschaltkomponente (17) an der ersten Arbeitsposition befindet, die Funktionsschaltkomponente (17) das Antriebsteil zum Bewegen antreiben kann; und
wenn sich die Funktionsschaltkomponente (17) an der ersten Arbeitsposition befindet, das Schiebeteil (24) in den ersten Sitzkörper (11) eingeführt werden kann und das Antriebsteil zum Bewegen durch die Funktionsschaltkomponente (17) schiebt, um zu ermöglichen, dass das erste Stromversorgungssteckteil (12) von der ersten Ausschaltposition zu der ersten Einschaltposition umgeschaltet wird und zu ermöglichen, dass das erste Signalsteckteil (14) von der zweiten Ausschaltposition zu der zweiten Einschaltposition umgeschaltet wird, und
das Schiebeteil (24) aus dem ersten Sitzkörper (11) gezogen werden kann, um zu ermöglichen, dass das erste Stromversorgungssteckteil (12) von der ersten Einschaltposition zu der ersten Ausschaltposition umgeschaltet wird, und zu ermöglichen, dass das erste Signalsteckteil (14) von der zweiten Einschaltposition zu der zweiten Ausschaltposition umgeschaltet wird.

2. Steckmechanismus der LED-Anzeigevorrichtung nach Anspruch 1, wobei
die Funktionsschaltkomponente (17) auch eine zweite Arbeitsposition und eine dritte Arbeitsposition aufweist,
wobei, wenn sich die Funktionsschaltkomponente (17) an der zweiten Arbeitsposition befindet, die Funktionsschaltkomponente (17) die erste Antriebskomponente (15) zum Bewegen und Vermeiden der zweiten Antriebskomponente (16) antreiben kann; wenn sich die Funktionsschaltkomponente (17) an der dritten Arbeitsposition befindet, die Funktionsschaltkomponente (17) die zweite Antriebskomponente (16) zum Bewegen und Vermeiden der ersten Antriebskomponente (15) antreiben kann;
wenn sich die Funktionsschaltkomponente (17) an der zweiten Arbeitsposition befindet, das Schiebeteil (24) die erste Antriebskomponente (15) zum Bewegen durch die Funktionsschaltkomponente (17) schiebt, um zu ermöglichen, dass das erste Stromversorgungssteckteil (12) von der ersten Ausschaltposition zu der ersten Einschaltposition umgeschaltet wird, und zu ermöglichen, dass das erste Signalsteckteil (14) an der zweiten Ausschaltposition gehalten wird; und
wenn sich die Funktionsschaltkomponente (17) an der dritten Arbeitsposition befindet, das Schiebeteil (24) die zweite Antriebskomponente (16) zum Bewegen durch die Funktionsschaltkomponente (17) schiebt, um zu ermöglichen, dass das erste Signalsteckteil (14) von der zweiten Ausschaltposition zu der zweiten Einschaltposition umgeschaltet wird, und zu ermöglichen, dass das erste Stromversorgungssteckteil (12) an der ersten Ausschaltposition gehalten wird.

3. Steckmechanismus der LED-Anzeigevorrichtung nach Anspruch 1, wobei die Funktionsschaltkomponente (17) auch eine vierte Arbeitsposition aufweist; wenn sich die Funktionsschaltkomponente (17) an der vierten Arbeitsposition befindet, die Funktionsschaltkomponente (17) das Antriebsteil vermeidet; und wenn sich die Funktionsschaltkomponente (17) an der vierten Arbeitsposition befindet, das Schiebeteil (24) die Funktionsschaltkomponente (17) zum Bewegen schiebt, um zu ermöglichen, dass das erste Stromversorgungssteckteil (12) an der ersten Ausschaltposition gehalten wird und zu ermöglichen, dass das erste Signalsteckteil (14) an der zweiten Ausschaltposition gehalten wird.

4. Steckmechanismus der LED-Anzeigevorrichtung nach Anspruch 1, wobei die erste Steckbaugruppe (10) ferner eine erste Rücksetzkomponente (21) und eine zweite Rücksetzkomponente (22) umfasst, die in dem ersten Sitzkörper (11) angeordnet sind; die erste Rücksetzkomponente (21) eine erste Rücksetzkraft zum Umschalten des ersten Stromversorgungssteckteils (12) von der ersten Einschaltposition zu der ersten Ausschaltposition zu der ersten Antriebskomponente (15) ausübt; und die zweite Rücksetzkomponente (22) eine zweite Rücksetzkraft zum Umschalten des ersten Signalsteckteils (14) von der zweiten Einschaltposition zu der zweiten Ausschaltposition zu der zweiten Antriebskomponente (16) ausübt.

5. Steckmechanismus der LED-Anzeigevorrichtung nach Anspruch 1, wobei die Funktionsschaltkomponente (17) ein Funktionsschaltstück (171) und eine erste Lasche (172) und eine zweite Lasche (173) umfasst, die an dem Funktionsschaltstück (171) in einem Intervall angeordnet sind; und wenn sich die Funktionsschaltkomponente (17) an der ersten Arbeitsposition befindet, die erste Lasche (172) die erste Antriebskomponente (15) zum Bewegen antreiben kann und die zweite Lasche (173) die zweite Antriebskomponente (16) zum Bewegen antreiben kann.

6. Steckmechanismus der LED-Anzeigevorrichtung nach Anspruch 2, wobei
die Funktionsschaltkomponente (17) ein Funktionsschaltstück (171) und eine erste Lasche (172) und eine zweite Lasche (173) umfasst, die an dem Funktionsschaltstück (171) in einem Intervall angeordnet sind, ein erster Spalt (174) zwischen der ersten Lasche (172) und einer Seite des Funktionsschaltstücks (171), die mit der ersten Lasche (172) bereitgestellt ist, gebildet ist, und ein zweiter Spalt (175) zwischen der zweiten Lasche (173) und einer Seite des Funktionsschaltstücks (171), die mit der zweiten Lasche (173) bereitgestellt ist, gebildet ist;
wenn sich die Funktionsschaltkomponente (17) an der ersten Arbeitsposition befindet, die erste Lasche (172) die erste Antriebskomponente (15) zum Bewegen antreiben kann und die zweite Lasche (173) die zweite Antriebskomponente (16) zum Bewegen antreiben kann;
wenn sich die Funktionsschaltkomponente (17) an der zweiten Arbeitsposition befindet, die erste Lasche (172) die erste Antriebskomponente (15) zum Bewegen antreiben kann und der zweite Spalt (175) die zweite Antriebskomponente (16) vermeidet; und
wenn sich die Funktionsschaltkomponente (17) an der dritten Arbeitsposition befindet, die zweite Lasche (173) die zweite Antriebskomponente (16) zum Bewegen antreiben kann und der erste Spalt (174) die erste Antriebskomponente (15) vermeidet.

7. Steckmechanismus der LED-Anzeigevorrichtung nach Anspruch 6, wobei die Funktionsschaltkomponente (17) ferner eine Betätigungstaste (176) in eingesetzter Passung mit dem Funktionsschaltstück (171) umfasst und die Betätigungstaste (176) das Funktionsschaltstück (171) zum Bewegen in dem ersten Sitzkörper (11) antreibt, um zu ermöglichen, dass die Funktionsschaltkomponente (17) zwischen der ersten Arbeitsposition, der zweiten Arbeitsposition und der dritten Arbeitsposition umgeschaltet wird.

8. Steckmechanismus der LED-Anzeigevorrichtung nach Anspruch 1, wobei die erste Antriebskomponente (15) einen Antriebsblock (151) und eine Antriebsplatte (153) umfasst, der Antriebsblock (151) bewegbar in dem ersten Sitzkörper (11) angeordnet ist, die Antriebsplatte (153) schwenkbar an dem ersten Sitzkörper (11) angeordnet ist und zwei Enden der Antriebsplatte (153) jeweils mit dem Antriebsblock (151) und dem ersten Stromversorgungssteckteil (12) artikuliert sind.

9. Steckmechanismus der LED-Anzeigevorrichtung nach Anspruch 8, wobei die Antriebsplatte (153) ein erstes Antriebsplattensegment (1531), ein Verbindungsplattensegment (1532) und ein zweites Antriebsplattensegment (1533) umfasst, die in Folge verbunden sind, das Verbindungsplattensegment (1532) an dem ersten Sitzkörper (11) durch eine Drehwelle angeordnet ist, das erste Antriebsplattensegment (1531) mit einer ersten Öffnung (1534) bereitgestellt ist, das zweite Antriebsplattensegment (1533) mit einer zweiten Öffnung (1535) bereitgestellt ist, der Antriebsblock (151) mit einer ersten artikulierten Säule (152) bereitgestellt ist, die an der ersten Öffnung (1534) anliegt, und das erste Stromversorgungssteckteil (12) mit einer zweiten artikulierten Säule (13) bereitgestellt ist, die an der zweiten Öffnung (1535) anliegt.

10. LED-Anzeigevorrichtung, umfassend eine erste Anzeigeeinheit (31), eine zweite Anzeigeeinheit (32) und einen Steckmechanismus, wobei die erste Anzeigeeinheit (31) und die zweite Anzeigeeinheit (32) Seite an Seite angeordnet sind, der Steckmechanismus der Steckmechanismus der LED-Anzeigevorrichtung nach einem der Ansprüche 1 bis 9 ist, die erste Steckbaugruppe (10) des Steckmechanismus an einer Seitenkante der ersten Anzeigeeinheit (31) benachbart zu der zweiten Anzeigeeinheit (32) montiert ist und die zweite Steckbaugruppe (20) des Steckmechanismus an einer Seitenkante der zweiten Anzeigeeinheit (32) benachbart zu der ersten Anzeigeeinheit (31) montiert ist.

## Revendications

1. Mécanisme enfichable d'un dispositif d'affichage à DEL, comprenant : un premier ensemble enfichable (10) et un second ensemble enfichable (20) qui coopèrent l'un avec l'autre, dans lequel
le premier ensemble enfichable (10) comprend un premier corps de siège (11), une première partie enfichable d'alimentation électrique (12), une première partie enfichable de signal (14), un premier composant d'entraînement (15), un second composant d'entraînement (16) et un composant de commutation de fonction (17), la première partie enfichable d'alimentation électrique (12) et la première partie enfichable de signal (14) sont agencées de manière mobile sur le premier corps de siège (11) à un intervalle, le premier composant d'entraînement (15) est agencé de manière mobile sur le premier corps de siège (11) et entraîne la première partie enfichable d'alimentation électrique (12) à se déplacer, le second composant d'entraînement (16) est agencé de manière mobile sur le premier corps de siège (11) et entraîne la première partie enfichable de signal (14) à se déplacer, et le premier composant d'entraînement (15) et le second composant d'entraînement (16) forment ensemble une partie d'entraînement ;
le second ensemble enfichable (20) comprend un second corps de siège (201), une seconde partie enfichable d'alimentation électrique (202), une seconde partie enfichable de signal (23) et une partie de poussée (24), la seconde partie enfichable d'alimentation électrique (202) et la seconde partie enfichable de signal (23) sont agencées sur le second corps de siège (201) à un intervalle, et la partie de poussée (24) fait saillie vers un côté extérieur du second corps de siège (201) et est agencée sur le second corps de siège (201) ;
la première partie enfichable d'alimentation électrique (12) présente une première position de mise sous tension où la première partie enfichable d'alimentation électrique (12) pénètre hors du premier corps de siège (11) et est en contact de mise sous tension avec la seconde partie enfichable d'alimentation électrique (202) et une première position de mise hors tension où la première partie enfichable d'alimentation électrique (12) se rétracte dans le premier corps de siège (11) et est séparée de la seconde partie enfichable d'alimentation électrique (202), et la première partie enfichable de signal (14) présente une seconde position de mise sous tension où la première partie enfichable de signal (14) pénètre hors du premier corps de siège (11) et est en contact de mise sous tension avec la seconde partie enfichable de signal (23) et une seconde position de mise hors tension où la première partie enfichable de signal (14) se rétracte dans le premier corps de siège (11) et est séparée de la seconde partie enfichable de signal (23) ;
le composant de commutation de fonction (17) est agencé de manière mobile sur le premier corps de siège (11), le composant de commutation de fonction (17) présente une première position de travail, et lorsque le composant de commutation de fonction (17) est situé dans la première position de travail, le composant de commutation de fonction (17) peut entraîner la partie d'entraînement à se déplacer ; et
lorsque le composant de commutation de fonction (17) est situé dans la première position de travail, la partie de poussée (24) peut être insérée dans le premier corps de siège (11) et pousse la partie d'entraînement à se déplacer au travers du composant de commutation de fonction (17), de façon à permettre à la première partie enfichable d'alimentation électrique (12) d'être commutée de la première position de mise hors tension à la première position de mise sous tension et à permettre à la première partie enfichable de signal (14) d'être commutée de la seconde position de mise hors tension à la seconde position de mise sous tension, et
la partie de poussée (24) peut être tirée hors du premier corps de siège (11), de manière à permettre à la première partie enfichable d'alimentation électrique (12) d'être commutée de la première position de mise sous tension à la première position de mise hors tension et à permettre à la première partie enfichable de signal (14) d'être commutée de la seconde position de mise sous tension à la seconde position de mise hors tension.

2. Mécanisme enfichable du dispositif d'affichage à DEL selon la revendication 1, dans lequel
le composant de commutation de fonction (17) présente également une deuxième position de travail et une troisième position de travail,
dans lequel lorsque le composant de commutation de fonction (17) est situé dans la deuxième position de travail, le composant de commutation de fonction (17) peut entraîner le premier composant d'entraînement (15) à se déplacer et éviter le second composant d'entraînement (16) ; lorsque le composant de commutation de fonction (17) est situé dans la troisième position de travail, le composant de commutation de fonction (17) peut entraîner le second composant d'entraînement (16) à se déplacer et éviter le premier composant d'entraînement (15) ;
lorsque le composant de commutation de fonction (17) est situé dans la deuxième position de travail, la partie de poussée (24) pousse le premier composant d'entraînement (15) à se déplacer au travers du composant de commutation de fonction (17), de façon à permettre à la première partie enfichable d'alimentation électrique (12) d'être commutée de la première position de mise hors tension à la première position de mise sous tension et à permettre à la première partie enfichable de signal (14) d'être maintenue dans la seconde position de mise hors tension ; et
lorsque le composant de commutation de fonction (17) est situé dans la troisième position de travail, la partie de poussée (24) pousse le second composant d'entraînement (16) à se déplacer au travers du composant de commutation de fonction (17), de façon à permettre à la première partie enfichable de signal (14) d'être commutée de la seconde position de mise hors tension à la seconde position de mise sous tension et à permettre à la première partie enfichable d'alimentation électrique (12) d'être maintenue dans la première position de mise hors tension.

3. Mécanisme enfichable du dispositif d'affichage à DEL selon la revendication 1, dans lequel le composant de commutation de fonction (17) présente également une quatrième position de travail ; lorsque le composant de commutation de fonction (17) est situé dans la quatrième position de travail, le composant de commutation de fonction (17) évite la partie d'entraînement ; et lorsque le composant de commutation de fonction (17) est situé dans la quatrième position de travail, la partie de poussée (24) pousse le composant de commutation de fonction (17) à se déplacer, de façon à permettre à la première partie enfichable d'alimentation électrique (12) d'être maintenue dans la première position de mise hors tension et à permettre à la première partie enfichable de signal (14) d'être maintenue dans la seconde position de mise hors tension.

4. Mécanisme enfichable du dispositif d'affichage à DEL selon la revendication 1, dans lequel le premier ensemble enfichable (10) comprend en outre un premier composant de réinitialisation (21) et un second composant de réinitialisation (22) qui sont agencés dans le premier corps de siège (11) ; le premier composant de réinitialisation (21) applique une première force de réinitialisation pour commuter la première partie enfichable d'alimentation électrique (12) de la première position de mise sous tension à la première position de mise hors tension au premier composant d'entraînement (15) ; et le second composant de réinitialisation (22) applique une seconde force de réinitialisation pour commuter la première partie enfichable de signal (14) de la seconde position de mise sous tension à la seconde position de mise hors tension au second composant d'entraînement (16).

5. Mécanisme enfichable du dispositif d'affichage à DEL selon la revendication 1, dans lequel le composant de commutation de fonction (17) comprend une pièce de commutation de fonction (171) et une première patte (172) et une seconde patte (173) qui sont agencées sur la pièce de commutation de fonction (171) à un intervalle ; et lorsque le composant de commutation de fonction (17) est situé dans la première position de travail, la première patte (172) peut entraîner le premier composant d'entraînement (15) à se déplacer, et la seconde patte (173) peut entraîner le second composant d'entraînement (16) à se déplacer.

6. Mécanisme enfichable du dispositif d'affichage à DEL selon la revendication 2, dans lequel
le composant de commutation de fonction (17) comprend une pièce de commutation de fonction (171) et une première patte (172) et une seconde patte (173) qui sont agencées sur la pièce de commutation de fonction (171) à un intervalle, un premier espace (174) est formé entre la première patte (172) et un côté de la pièce de commutation de fonction (171) pourvu de la première patte (172), et un second espace (175) est formé entre la seconde patte (173) et un côté de la pièce de commutation de fonction (171) pourvu de la seconde patte (173) ;
lorsque le composant de commutation de fonction (17) est situé dans la première position de travail, la première patte (172) peut entraîner le premier composant d'entraînement (15) à se déplacer, et la seconde patte (173) peut entraîner le second composant d'entraînement (16) à se déplacer ;
lorsque le composant de commutation de fonction (17) est situé dans la deuxième position de travail, la première patte (172) peut entraîner le premier composant d'entraînement (15) à se déplacer, et le second espace (175) évite le second composant d'entraînement (16) ; et
lorsque le composant de commutation de fonction (17) est situé dans la troisième position de travail, la seconde patte (173) peut entraîner le second composant d'entraînement (16) à se déplacer, et le premier espace (174) évite le premier composant d'entraînement (15).

7. Mécanisme enfichable du dispositif d'affichage à DEL selon la revendication 6, dans lequel le composant de commutation de fonction (17) comprend en outre une touche de commande (176) en ajustement inséré avec la pièce de commutation de fonction (171), et la touche de commande (176) entraîne la pièce de commutation de fonction (171) à se déplacer dans le premier corps de siège (11), de façon à permettre au composant de commutation de fonction (17) d'être commuté parmi la première position de travail, la deuxième position de travail et la troisième position de travail.

8. Mécanisme enfichable du dispositif d'affichage à DEL selon la revendication 1, dans lequel le premier composant d'entraînement (15) comprend un bloc d'entraînement (151) et une plaque d'entraînement (153), le bloc d'entraînement (151) est agencé de manière mobile dans le premier corps de siège (11), la plaque d'entraînement (153) est agencée de manière balançante sur le premier corps de siège (11), et deux extrémités de la plaque d'entraînement (153) sont respectivement articulées avec le bloc d'entraînement (151) et la première partie enfichable d'alimentation électrique (12).

9. Mécanisme enfichable du dispositif d'affichage à DEL selon la revendication 8, dans lequel la plaque d'entraînement (153) comprend un premier segment de plaque d'entraînement (1531), un segment de plaque de liaison (1532) et un second segment de plaque d'entraînement (1533) qui sont reliés en séquence, le segment de plaque de liaison (1532) est agencé sur le premier corps de siège (11) au travers d'un arbre rotatif, le premier segment de plaque d'entraînement (1531) est pourvu d'une première ouverture (1534), le second segment de plaque d'entraînement (1533) est pourvu d'une seconde ouverture (1535), le bloc d'entraînement (151) est pourvu d'une première colonne articulée (152) en butée contre la première ouverture (1534), et la première partie enfichable d'alimentation électrique (12) est pourvue d'une seconde colonne articulée (13) en butée contre la seconde ouverture (1535).

10. Dispositif d'affichage à DEL, comprenant une première unité d'affichage (31), une seconde unité d'affichage (32) et un mécanisme enfichable, dans lequel la première unité d'affichage (31) et la seconde unité d'affichage (32) sont agencées côte à côte, le mécanisme enfichable est le mécanisme enfichable du dispositif d'affichage à DEL selon l'une quelconque des revendications 1 à 9, le premier ensemble enfichable (10) du mécanisme enfichable est monté sur un bord latéral de la première unité d'affichage (31) adjacent à la seconde unité d'affichage (32), et le second ensemble enfichable (20) du mécanisme enfichable est monté sur un bord latéral de la seconde unité d'affichage (32) adjacent à la première unité d'affichage (31).
